(19) Europäisches Patentamt
European Patent Office
Office européen des brevets

(11) **EP 4 607 568 A1**

(12) **EUROPEAN PATENT APPLICATION**

(43) Date of publication:
**27.08.2025 Bulletin 2025/35**

(21) Application number: **24216737.7**

(22) Date of filing: **02.12.2024**

(51) International Patent Classification (IPC):
**H01J 1/304** (2006.01)    **H01J 1/308** (2006.01)
**H01J 35/06** (2006.01)

(52) Cooperative Patent Classification (CPC):
**H01J 1/3042; H01J 1/3044; H01J 1/308;**
**H01J 35/065;** H01J 2201/30411; H01J 2201/3048;
H01J 2201/308; H01J 2235/062

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **22.02.2024 KR 20240025975**

(71) Applicant: **LG Electronics Inc.**
**Yeongdeungpo-gu**
**Seoul 07336 (KR)**

(72) Inventors:
• **NAM, Hyojin**
**06772 Seoul (KR)**
• **LEE, Byungkee**
**06772 Seoul (KR)**

• **KIM, Jinah**
**06772 Seoul (KR)**
• **LEE, Giwon**
**06772 Seoul (KR)**
• **KIM, Youngsik**
**06772 Seoul (KR)**
• **YIM, Jeongsoon**
**06772 Seoul (KR)**
• **HONG, Eunju**
**06772 Seoul (KR)**

(74) Representative: **Vossius & Partner**
**Patentanwälte Rechtsanwälte mbB**
**Siebertstrasse 3**
**81675 München (DE)**

Remarks:
Amended claims in accordance with Rule 137(2)
EPC.

(54) **PACKAGE HAVING FIELD EMISSION ELEMENT AND X-RAY DEVICE HAVING THE SAME**

(57)    A package having a field emission element may include a handle layer; a buried layer stacked on the handle layer; a device layer stacked on the buried layer; an insulating layer stacked in an upper region of the device layer; a gate electrode stacked in an upper region of the insulating layer; and at least one light-emitting element disposed in a lower region of the device layer, and configured to emit light through the device layer. The insulating layer may be configured with a plurality of insulating regions separated by first separation regions, and the gate electrode may be configured with a plurality of metal regions separated by second separation regions. The device layer may be provided with protruding portions disposed to protrude between the first separation regions between the insulating regions and the second separation regions between the metal regions.

FIG. 13

## Description

## BACKGROUND

## Field

The present disclosure relates to a package having a field emission element. More specifically, the present disclosure relates to a package having a field emission element and an X-ray device having the same.

## Description of the Related Art

In a probe-type field emission element, the field emission current density is very sensitive to a shape of a probe (height, probe radius, etc.). In particular, the probe radius is on the order of several nm, and a slight difference in the radius may result in a rapid increase in the current density of a particular probe. Therefore, the shape of the probe may be deformed or micro arc plasma may cause an electrical short to the gate electrode, which can lead to serious reliability problems.

Various methods are being attempted to ensure reliability while maintaining a high current density. However, it is a very difficult task to completely resolve reliability issues caused by arcing.

In the case of a silicon probe, since the probe is manufactured by etching a silicon wafer, there is a problem in that it is difficult to form a separate resistive layer under the probe, and therefore, there is no report on a current-limiting resistive layer.

For n-type silicon, where electrons are majority carriers, high current densities can be obtained. However, reliability is a problem because it is difficult to avoid an arcing phenomenon caused by local plasma generation.

To ensure reliability, a p-type wafer in which majority carriers are holes or a silicon emitter using a p-n junction may be taken into consideration. In this case, high reliability may be achieved, but the current density may be limited due to the lack of electrons that can be emitted, and high current cannot be obtained.

As a way to overcome reliability and current density limitations, a transistor such as a MOSFET or JFET may be manufactured to control a current thereof by controlling a gate voltage of the transistor. However, there is a problem in that the density of the probe is reduced because the manufacturing process is complex and an additional area is required to form the transistor.

## SUMMARY

An aspect of this specification is to provide a package having a field emission element and an X-ray device having the same

Another aspect of this specification is to increase current density and ensure reliability in a package and an X-ray device.

Still another aspect of this specification is to provide a structure and method of an element integrated with a probe formed from a p-type wafer and an LED (or LD).

Yet still another aspect of this specification is to ensure reliability by preventing an excessive current from flowing through each individual probe and to control a current density for emitting electrons by controlling an intensity of LED light.

A package having a field emission element according to this specification may include a handle layer; a buried layer stacked on the handle layer; a device layer stacked on the buried layer; an insulating layer stacked in an upper region of the device layer; a gate electrode stacked in an upper region of the insulating layer; and at least one light-emitting element disposed in a lower region of the device layer, and configured to emit light through the device layer. The insulating layer may be configured with a plurality of insulating regions separated by first separation regions, and the gate electrode may be configured with a plurality of metal regions separated by second separation regions. The device layer may be provided with protruding portions disposed to protrude between the first separation regions between the insulating regions and the second separation regions between the metal regions.

According to an embodiment, the device layer may be disposed with a p-type silicon substrate. The protruding portions of the device layer may be formed of n-type silicon.

According to an embodiment, an upper region of the protruding portions may be formed of n-type silicon. A lower region of the protruding portions and a body portion of the device layer may be disposed with a p-type silicon substrate. The body portion of the device layer may be disposed to be flat so as to allow the insulating layer to be disposed on a top thereof.

According to an embodiment, the protruding portions and an upper region of a body portion of the device layer disposed integrally with the protruding portions may be formed of n-type silicon. A lower region of the body portion may be disposed with a p-type silicon substrate. The buried layer may be stacked on a bottom of the lower region of the body portion.

According to an embodiment, the package may further include an SOI wafer at a central portion of which a recessed region is formed by an etching process. One side region and the other side region of the central portion of the wafer may be disposed with protruding regions disposed to protrude beyond the recessed region. A first thickness from a bottom of the wafer to tops of the protruding regions may be disposed to be thicker than a second thickness from the bottom of the wafer to a top of the recessed region.

According to an embodiment, the package may further include a first oxide layer disposed in the recessed region on a top of the wafer and in protruding regions on one side and the other side of the recessed region; and a second oxide layer disposed on a bottom of the wafer. The package may further include first metal electrodes disposed in the protruding regions; and a second metal electrode disposed in the recessed region. The light-emitting element may be disposed on a top of the second metal electrode.

According to an embodiment, the first metal electrodes may constitute LED cathodes, and the second metal electrode may constitute an LED anode. A bottom of the light-emitting element may be disposed in the recessed region in which the second metal electrode is disposed, and a top of the light-emitting element may be disposed in an opening region of the handle layer.

According to an embodiment, the light-emitting element may be disposed with a plurality of LEDs spaced apart on a vertical axis in a region where the second metal electrode is disposed. One side and the other side of each of the plurality of LEDs may be connected to the first metal electrodes of one side and the other side of the protruding region by wire bonding.

According to an embodiment, the package may include a thin film stacked on a bottom of one side region and a bottom of the other side region of the handle layer - a central portion of the handle layer is removed by an etching process, and the handle layer is disposed on the one side region and the other side region to allow an opening region to be disposed in the central portion; and a transparent electrode disposed on a bottom of the thin film, an inner surface of the one side region, an inner surface of the other side region, and a bottom of the device layer

According to an embodiment, the package may include a second thin film disposed on a bottom of the transparent electrode, and an inner surface of one side region and an inner surface of the other side region of the transparent electrode. The second thin film may constitute the opening region disposed at a central portion of the transparent electrode stacked on the device layer. The opening region may be disposed to have a first opening length at a top of the handle layer, and disposed to have a second opening length at a bottom of the handle layer.

According to an embodiment, the second opening length may be disposed to be larger than the first opening length. A horizontal axis length of the light-emitting elements may be disposed to be smaller than the first opening length.

According to an embodiment, a gate voltage may be applied to at least one of the gate electrode and the first metal electrodes. A drive voltage may be applied to at least one of the second metal electrode and the first metal electrodes.

According to an embodiment, an anode layer may be disposed on a surface of a detector configured to detect an electron beam from the field emission element. An anode voltage may be applied to at least one of the anode layer and the first metal electrodes.

According to an embodiment, the gate voltage may be varied. A fixed voltage may be applied to the anode voltage. An emission current of an electron beam emitted by the light-emitting elements may increase as the gate voltage increases when the drive voltage is not applied.

According to an embodiment, when the light-emitting element emits light due to the application of the drive voltage, the emission current may increase at a first slope in a range of the gate voltage from 50 V to a first drive voltage. When the light-emitting element emits light, the emission current may increase at a second slope that is smaller than the first slope in a range of the gate voltage from the first drive voltage to 100 V The emission current may be greater than 100 $\mu$A at the first drive voltage.

An X-ray device having a field emission element according to another aspect of the present specification may include a body having a front surface, a rear surface and a plurality of side surface to constitute an exterior of the X-ray device; an electron emission device disposed internally through one side surface of the body; and an X-ray emission device disposed internally through the other side surface of the body, and configured to reflect an electron beam emitted from the electron emission device and radiate the reflected beam to an outside of the body through the front surface. The electron emission device may include a handle layer; a buried layer stacked on the handle layer; a device layer stacked on the buried layer; an insulating layer stacked in an upper region of the device layer; a gate electrode stacked in an upper region of the insulating layer; and at least one light-emitting element disposed in a lower region of the device layer, and configured to emit light through the device layer. The insulating layer may be configured with a plurality of insulating regions separated by first separation regions, and the gate electrode may be configured with a plurality of metal regions separated by second separation regions. The device layer may be provided with protruding portions disposed to protrude between the first separation regions between the insulating regions and the second separation regions between the metal regions.

According to this specification, a package having a field emission element and an X-ray device having the same may be provided.

According to this specification, a current of each individual probe may be effectively controlled to increase current density and secure reliability in a package and X-ray device.

According to this specification, a structure and method of an element integrated with a probe formed from a p-type wafer and an LED (or LD) may be provided by using a principle that carriers are generated when a p-type or p-n junction receives light energy.

According to this specification, a current may be controlled by light of a light-emitting element to ensure reliability by preventing an excessive current from flowing through each individual probe and to control a current density for emitting electrons by controlling an intensity of LED light.

## BRIEF DESCRIPTION OF THE DRAWINGS

The above and other aspects, features and other advantages of the present disclosure will be more clearly understood from the following detailed description taken in conjunction with the accompanying drawings, in which:

> FIG. 1 shows a cross-sectional view and current-voltage characteristics of an n-type field emission element in the related art;
> FIG. 2 shows a cross-sectional view and current-voltage characteristics of a p-type field emission element in the related art;
> FIG. 3 shows a cross-sectional view and current-voltage characteristics of a p-n junction field emission element in the related art;
> FIGS. 4 and 5 show process diagrams of manufacturing a field emission element;
> FIGS. 6 and 7 show process diagrams of a lower structure of a package having a field emission element;
> FIG. 8 shows a plan view of a lower structure of FIG. 6 in which light-emitting elements are disposed;
> FIGS. 9 and 10 show cross-sectional views along different axes of a package having a field emission element in which light-emitting elements are disposed in a lower structure thereof;
> FIGS. 11 and 12 show cross-sectional views of an LED integrated device having a P-N junction according to embodiments;
> FIG. 13 shows a configuration in which bias voltages are applied to a package having a field emission element;
> FIG. 14 shows an emission current emitted through light-emitting elements according to a change of a gate voltage; and
> FIG. 15 shows a configuration of an X-ray device having a field emission element according to this specification.

## DETAILED DESCRIPTION OF THE EMBODIMENTS

A technology disclosed herein is applied to a package having a field emission element and an X-ray device having the same. However, a technology disclosed herein is not limited thereto, and may also be applied to a package including all field emission elements to which the technical concept of the technology can be applied, and an X-ray device including the same.

It should be noted that technical terms used herein are merely used to describe a specific embodiment, but not to limit the present disclosure. Furthermore, unless particularly defined otherwise, technical terms used herein should be construed as a meaning generally understood by those skilled in the art to which the present disclosure pertains, and should not be construed too broadly or too narrowly. In addition, if technical terms used herein are wrong technical terms unable to correctly express the concept of the present disclosure, then they should be replaced by technical terms that are properly understood by those skilled in the art. Moreover, general terms used herein should be construed based on the definition of dictionaries, or based on the context, and should not be construed too broadly or too narrowly.

Besides, a singular expression used herein may include a plural expression unless clearly defined otherwise in the context. As used herein, the terms "comprising" and "including" should not be construed to necessarily include all elements or steps disclosed herein, and should be construed not to include some elements or some steps thereof, or should be construed to further include additional elements or steps.

Furthermore, the suffixes "module" and "unit" used for elements herein are used only to simplify the disclosure, and do not have meanings or functions that distinguish elements from one another in themselves.

In addition, the terms including an ordinal number such as first, second, and the like as used herein may be used to describe various elements, but the elements must not be limited by those terms. The terms are used merely for the purpose to distinguish an element from another element. For example, a first element may be referred to as a second element, and similarly, a second element may be referred to as a first element without departing from the scope of the present disclosure.

Hereinafter, preferred embodiments of the present disclosure will be described in detail with reference to the accompanying drawings, and the same or similar element are designated with the same numeral references regardless of the numerals in the drawings and a redundant description thereof will be omitted.

In addition, in describing the present disclosure, a detailed description of known related technologies will be omitted to avoid unnecessarily obscuring the subject matter of the present disclosure. Moreover, it should be noted that the accompanying drawings are merely illustrated to easily understand the concept of the present disclosure, and thus should not be construed to limit the concept of the present disclosure by the accompanying drawings.

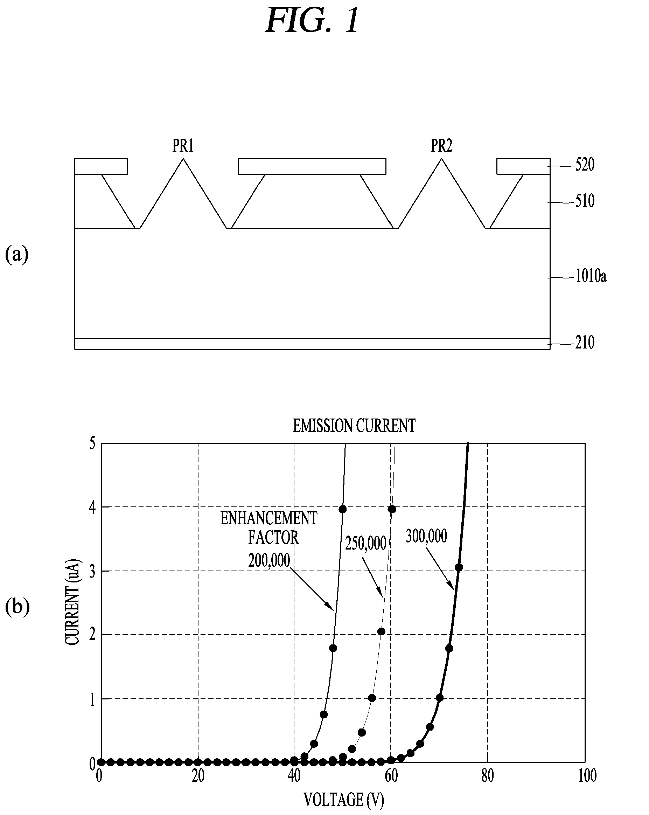

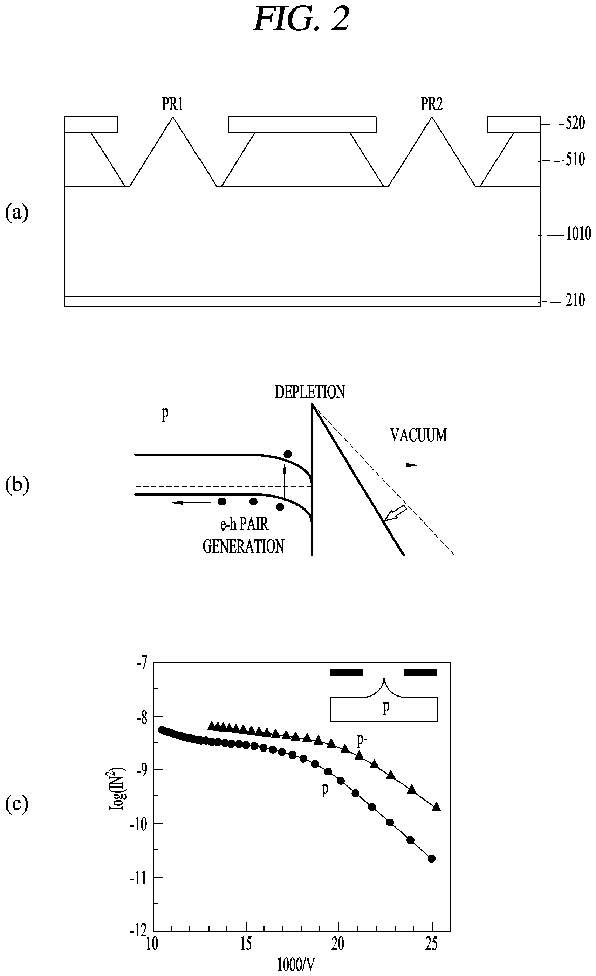

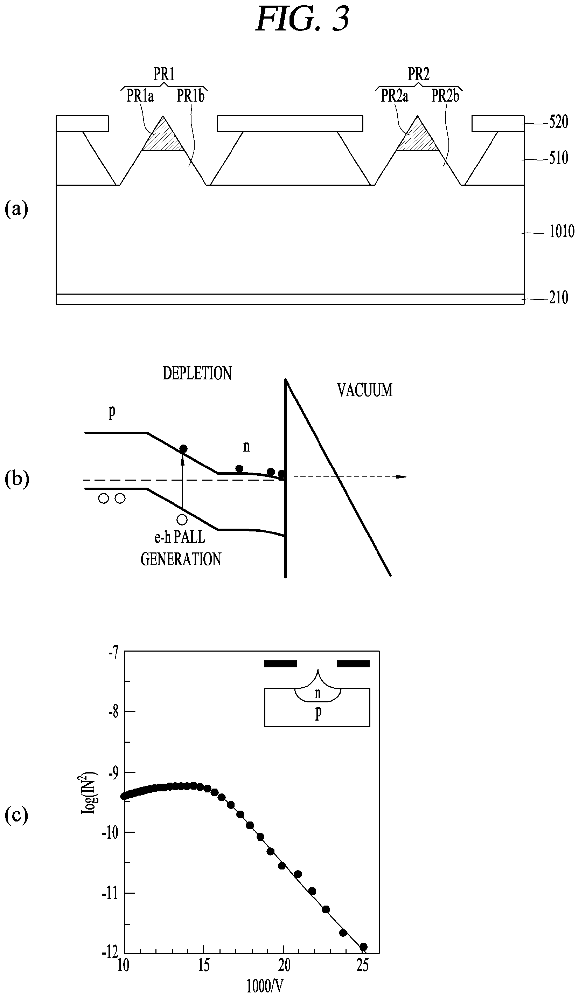

In this regard, FIG. 1 shows a cross-sectional view and current-voltage characteristics of an n-type field emission element in the related art. FIG. 2 shows a cross-sectional view and current-voltage characteristics of a p-type field emission element in the related art. FIG. 3 shows a cross-sectional view and current-voltage characteristics of a p-n junction field emission element in the related art.

(a) of FIG. 1 shows a cross-sectional view of an n-type field emission element. (b) of FIG. 1 shows current-voltage characteristics of an n-type field emission element of (a) of FIG. 1. Referring to (a) of FIG. 1, protruding portions PR1, PR2 disposed with probe portions may be formed through etching a wafer 1010a made of a silicon material. The wafer 1010a may be disposed with an n-type silicon substrate. An insulating layer 510 may be disposed between the protruding portions PR1, PR2. A gate electrode 520 may be disposed in an upper region of the insulating layer 510.

A first electrode 1210, which is a cathode electrode, may be disposed in a lower region of the wafer 1010a. When a voltage is applied between the first electrode 1210 and the gate electrode 520, an electric field is concentrated on the protruding portions PR1, PR2 disposed with pointed probes at end portions thereof. Accordingly, a tunnel barrier in vacuum becomes thinner. This causes electrons from the probe-shaped protruding portions PR1, PR2 to be emitted into the vacuum through a tunneling phenomenon. A tunneling current J may be expressed by Equation 1 below.

[Equation 1]

$$J(V, \phi, \beta) = 1.42 \times 10^{-6} \times \beta^2 \times \exp\left(\frac{10.4}{\phi^{1/2}}\right)$$
$$\times \frac{V^2}{\phi} \exp\left(-\frac{6.44 \times 10^7 \times \phi}{V \times \beta}\right)$$

Here, V is a voltage applied to a field emission element, $\varphi$ is a work function of a material, and $\beta$ is a field enhancement factor. The tunneling current J is very sensitive to the field enhancement factor $\beta$. The field enhancement factor is a value that represents an increase in the electric field on a probe surface depending on a shape of the probe, which is proportional to a height of the probe and inversely proportional to a radius of the probe.

Referring to (b) of FIG. 1, voltage-current characteristics of a field emission element based on Equation 1 of a tunneling current J are shown. It can be seen that the current changes very sensitively to a voltage and a field enhancement factor, for example, similarly to an exponential function.

Although the voltage can be controlled at a constant level, it is very difficult to maintain the field enhancement factor to be constant. The field enhancement factor varies with a radius of the probe, and it is almost impossible to maintain a uniform radius of the probe on the order of several nm. It also changes very sensitively depending on surface contamination, or the like. Therefore, even when the same voltage is applied to each individual probe, the current differs greatly. Therefore, even when a particular probe does not emit electrons, arcing may occur at other probe portions due to an excessive current. Accordingly, an electrical short to the gate electrode may occur, which may result in a critical reliability problem.

Meanwhile, in connection with a field emission element according to this specification, it is necessary to prevent arching. To this end, for a field emission element, a diode-type element and a transistor-type element may be taken into consideration. (a) of FIG. 2 is a cross-sectional view of a field emission element using a p-type wafer. (b) and (c) of FIG. 2 show a band diagram and a F-N (Fowler-Nordheim) graph for a field emission element using a p-type wafer.

Referring to (a) of FIG. 2, protruding portions PR1, PR2 disposed with probe portions may be formed through etching a wafer 1010a made of a silicon material. The wafer 1010a may be disposed with a p-type silicon substrate. An insulating layer 510 may be disposed between the protruding portions PR1, PR2. A gate electrode 520 may be disposed in an upper region of the insulating layer 510. A first electrode 1210, which is a cathode electrode, may be disposed in a lower region of the wafer 1010a.

In the p-type wafer 1010a, the supply of electrons is limited as electrons are minority carriers, which may be used to limit an excessive current flowing through the probe. Referring to the energy band diagram in (b) of FIG. 2, a depletion layer is generated in a boundary region. Electron-hole pairs generated by thermal generation in the depletion layer are a main source of electrons. Therefore, when the electrical resistance is high, a size of the depletion layer increases, which may increase the current. Referring to the F-N plot in (c) of FIG. 2, it can be seen that the F-N emission characteristics are exhibited at low voltages, and the current is limited at high voltages by limiting the supply of electrons due to the p-type wafer.

In this way, arcing may be prevented by suppressing a high current from flowing to the protruding portions PR1, PR2, which are probe portions. However, there is a limitation in obtaining a high current required in a field emission element by limiting the supply of electrons.

Meanwhile, as a related art, there is also a field emission element with a p-n junction structure. (a) of FIG. 3 is a cross-sectional view of a field emission element configured with a p-n junction structure. (b) and (c) of FIG. 3 show an energy band diagram and an F-N graph for a field emission element configured with a p-n junction structure.

Referring to (a) of FIG. 3, protruding portions PR1, PR2 disposed with probe portions may be formed through etching a wafer 1010a made of a silicon material. The wafer 1010a may be disposed with a pn-type silicon substrate. Upper regions PR1a, PR2a of the protruding portions PR1, PR2 may be disposed with n-type doped silicon probe portions. Lower regions PR1b, PR2b of the protruding portions PR1, PR2 and the wafer 1010a may be formed of p-type silicon. An insulating layer 510 may be disposed between the protruding portions PR1, PR2. A gate electrode 520 may be disposed in an upper region of the insulating layer 510. A first electrode 1210, which is a cathode electrode, may be disposed in a lower region of the wafer 1010a.

Referring to the band diagram in (b) of FIG. 3, electron-hole pairs in a depletion layer disposed at a p-n junction portion are a main source of electrons. Therefore, the supply of electrons is affected by a size of the depletion layer at the p-n junction. That is, as a size of the depletion layer increases, the current increases. Referring to the F-N plot in (c) of FIG. 3, emission characteristics similar to a p-type emitter are exhibited, but the limitation of the current is clearly shown at high voltages. This exhibits the same characteristics in that the current in reverse bias in a p-n diode does not increase with voltage but remains almost constant.

As a way to overcome reliability and current density limitations, a transistor such as a MOSFET or JFET may also be manufactured to control a current thereof by controlling a gate voltage of the transistor. However, the manufacturing process is complex and an additional area is required to form the transistor, and there is a limitation in that a number of probe portions per unit area is greatly reduced.

As a way to increase electron-hole pairs in an element using a p-type or p-n junction, the emission current may be increased by illuminating the device with light, but no specific method for element fabrication has been proposed.

The present disclosure will describe a field emission element capable of increasing an emission current while limiting a current sensitivity according to a radius of the probe, and the like. The operating principle of a field emission element is that when a high electric field of 107 to 108 V/cm is applied to a metal or semiconductor surface in a vacuum, a potential barrier of the semiconductor surface is reduced. This refers to a phenomenon in which electrons are emitted into a vacuum state by a quantum mechanical tunneling effect through which electrons pass through the reduced potential barrier on the semiconductor surface, which is called Fowler-Nordheim tunneling (F-N tunneling).

The most effective way to lower an electric field for F-N tunneling is to form a sharp probe on the order of several nm to tens of nm. By forming the probe in this manner, an electric field may be concentrated at a tip of the probe in proportion to a height of a probe emitter as well as in inverse proportion to a radius of the tip of the probe portion, thereby reducing the drive voltage to several tens of V. However, for n-type silicon wafer, the element is prone to destruction due to arcing caused by a high current from a specific probe due to current non-uniformity of the probe.

Meanwhile, an element using p-type has a problem in that a high emission current required for a medical field emission element cannot be obtained due to insufficient current supply.

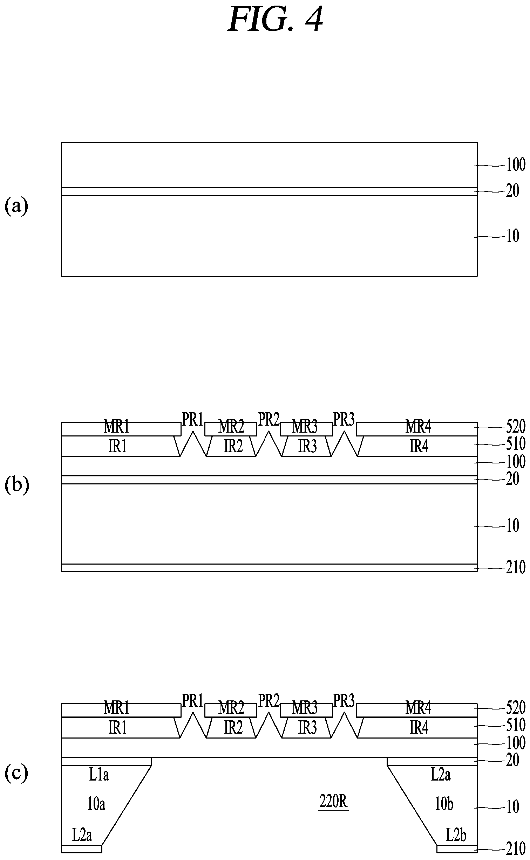

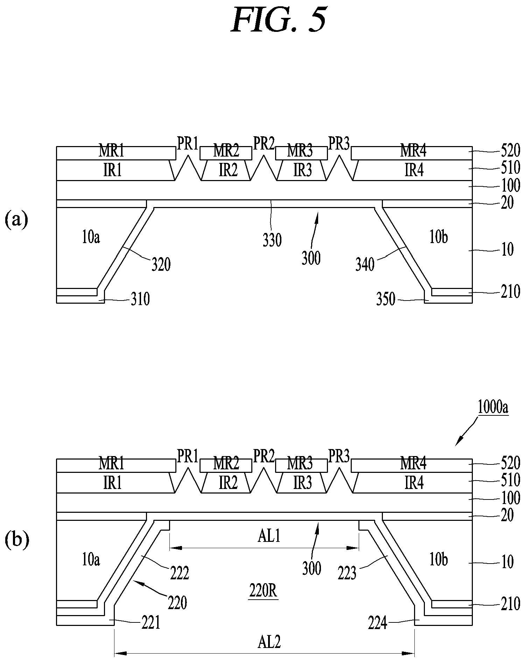

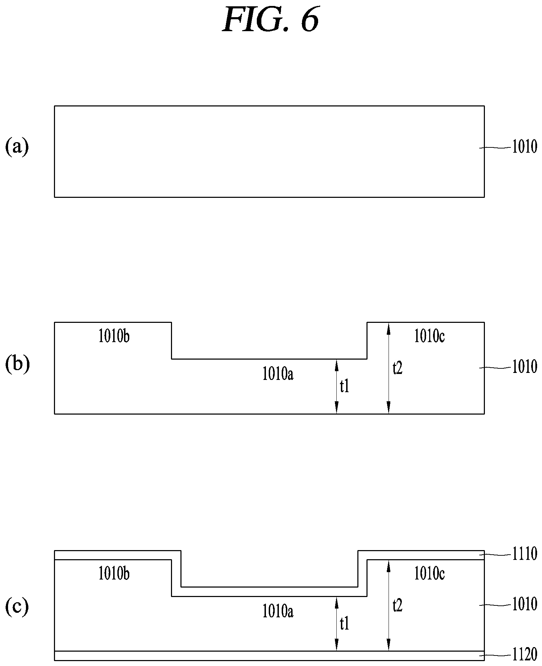

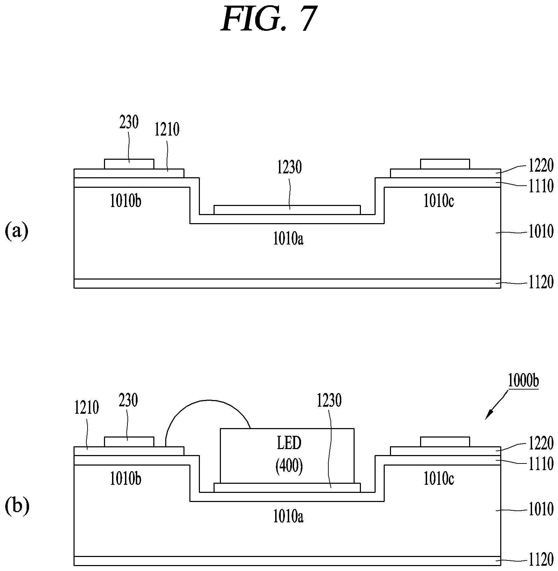

A field emission element according to this specification may increase an emission current while limiting current sensitivity according to a radius thereof, or the like. A package having a field emission element according to this specification and an X-ray device having the field emission element will be described in detail with reference to the drawings. In this regard, FIGS. 4 and 5 show process diagrams of manufacturing a field emission element. FIGS. 6 and 7 show process diagrams of a lower structure of a package having a field emission element.

Referring to (a) of FIG. 4, the field emission element of the present disclosure is manufactured using a silicon on insulator (SOI) in which a buried layer 20 is stacked in a lower region of a device layer 100. The device layer may be disposed with a p-type silicon substrate to limit current sensitivity, the buried layer 20 may be disposed with a silicon oxide film ($SiO_2$), and the handle layer 10 may be a silicon wafer, which is either p-type or n-type.

Referring to (b) of FIG. 4, a top portion in a first region of the device layer 100 may be removed, and protruding portions PR1, PR2, PR3 that act as probe portions may be disposed in a second region from which the top portion is not removed. Insulating regions IR1, IR2, IR3, IR4 may be disposed in an upper region of the first region from which the top portion has been removed. A plurality of insulating regions IR1, IR2, IR3, IR4 may constitute an insulating layer 510. Metal regions MR1, MR2, MR3, MR4 may be disposed in an upper region of the insulating layer 510. A plurality of metal regions MR1, MR2, MR3, MR4 may constitute a gate electrode 520. In addition, a thin film 210 may be disposed in a lower region of the device layer 100.

A frontside of the field emission element has the same structure as a typical silicon field emission element, but silicon etching and electrode formation structures are additionally required on a backside thereof. The reason that silicon etching on the backside is necessary is to ensure that light radiated from a light-emitting element such as an LED may easily reach a surface of the element where the depletion layer is located.

In this regard, when the handle layer 10 made of a silicon material is not etched, most of the light will be absorbed by the handle layer 10 made of a silicon material, and will not reach the device layer 100 and the protruding portions PR1, PR2, PR3 that act as probe portions.

Referring to (c) of FIG. 4, a central portion of the handle layer 10 made of a silicon material may be etched and removed. The handle layer 10 may be divided into a first region 10a of the handle layer and a second region 10b of the handle layer based on the etched and removed central portion. A hole region may be disposed in the central portion of the handle layer 10. The handle layer 10 may be divided into a first region 10a of the handle layer and a second region 10b of the handle layer based on the center of the hole region in the central portion that has been etched and removed. The first region 10a of the handle layer and the second region 10b of the handle layer are disposed integrally to constitute the handle layer 10.

The first region 10a of the handle layer may be disposed on one side of a lower portion of the device layer 100. The second region 10b of the handle layer may be disposed on the other side of a lower portion of the device layer 100. A top length L1a of the first region 10a of the handle layer may be disposed to be larger than a bottom length L1b thereof. A top length L1b of the second region 10b of the handle layer may be disposed to be larger than a bottom length L2b thereof. The thin film 210 disposed in a lower region of the device layer 100 may also have its central portion removed and be disposed on both sides thereof. A length of the thin film 210 disposed on both sides thereof may be disposed to be the same as bottom lengths L1b, L2b of the first and second regions 10a, 10b of the handle layer. The thin film 210 may be disposed with a $Si_3N_4$ thin film layer deposited on the handle layer 10.

A top length L1 a of the first region 10a of the handle layer and a top length L1b of the second region 10b of the handle layer may be disposed to be the same. A bottom length L1b of the first region 10a of the handle layer and a bottom length L2b of the second region 10b of the handle layer may be disposed to be the same. The first region 10a of the handle layer and the second region 10b of the handle layer are disposed in a symmetrical structure based on a center line of the field emission element, thereby securing mechanical stability despite the formation of an opening region 220R by an etching process. In particular, top lengths L1a, L2a of the first and second regions 10a, 10b of the handle layer are disposed to be larger than bottom lengths L1b, L2b thereof so as to allow a plurality of light-emitting elements to be disposed in a lower region. Therefore, it is advantageous to etch the handle layer 10 made of a silicon material to secure a space for integrating an LED as a light-emitting element. In addition, an area of an upper region of the opening region 220R may be disposed to be narrower than that of a lower region thereof to concentrate a light collection region by the light-emitting elements, thereby increasing the emission current per unit area.

Meanwhile, it is very difficult to control the etching speed to leave a constant and thin silicon thickness through silicon etching. In particular, the buried layer 20 disposed to be thinner than the handle layer 10 must also have its central portion removed by an etching process. Therefore, in this specification, a silicon structure having a predetermined thickness may be left on both sides by an etching process using an SOI wafer.

A manufacturing process may be briefly described as follows. A silicon emitter is formed using the device layer 100 made of a SOI wafer. A process of forming the protruding portions PR1, PR2, PR3, which are probe portions, forming the insulating layer 510, forming the gate electrode 520, or the like may be carried out in the same or similar manner as or to the process of forming a silicon emitter. Various methods for forming a silicon emitter have been developed, and those silicon emitter manufacturing processes may also be applied to a silicon etching process or the like in this specification. In this case, the device layer 100 may use a p-type wafer doped with boron and may have a thickness in a range of approximately 2 to 50 μm.

Subsequent to the silicon emitter manufacturing process, an additional process is carried out as follows. First, silicon may be etched from a rear surface thereof. An anisotropic etching method using a solution such as KOH, TMAH or the like may be used for silicon etching, and an $Si_3N_4$ thin film deposited by an LPCVD method may be used for an etching mask. In addition, silicon may be etched by using a dry etching method such as deep RIE, but there is a problem in that deposition on a side surface thereof is difficult when forming an electrode. When etching silicon, the etching almost stops when the etching solution comes into contact with the buried oxide (BOX) layer ($SiO_2$), and additionally, the BOX layer may be etched so as to allow only the device layer 100 to remain.

Electrical connection of the device layer that acts as a cathode is required, but since it must transmit light as well as provide electrical connection, the transparent electrode 300 is deposited. Referring to (a) of FIG. 5, the transparent electrode 300 may be disposed between a bottom of the thin film 210 disposed on both sides thereof, an inner side of the handle layer 10, and the buried layer 20. Since the thin film 210 has no special role after silicon etching, it may be removed and ITO may be directly deposited under the handle layer. Indium tin oxide (ITO) may be used for the transparent electrode, but may not be limited thereto and various transparent electrodes may also be used depending on the application. Subsequent to depositing the transparent electrode 300, a metal layer such as gold (Au) may be deposited for adhesion to an LED integrated substrate. Ti, Cr or the like may be used as an adhesion layer during Au deposition.

The transparent electrode 300 may be configured with a plurality of portions. The transparent electrode 300 may be configured to include a first portion 310, a second part 320, a third portion 330, a fourth portion 340, and a fifth portion 350. The first portion 310 of the transparent electrode 300 may be disposed under the thin film layer 210 disposed under the first region 10a of the handle layer. The second portion 320 of the transparent electrode 300 may be connected to the first portion 310 and the third portion 330 of the transparent electrode 300. The second portion 320 of the transparent electrode 300 may be disposed in an inner region of the first region 10a of the handle layer configured with an inclined structure.

The third portion 330 of the transparent electrode 300 may be connected to the second portion 320 and the fourth portion 340 of the transparent electrode 300. The third portion 330 of the transparent electrode 300 may be disposed between the buried layers 20 disposed on tops of the first and second regions 10a, 10b of the handle layer. The third portion 330 of the transparent electrode 300 may be disposed at a bottom of the device layer 100.

The fourth portion 340 of the transparent electrode 300 may be connected to the third portion 330 and the fifth portion 350 of the transparent electrode 300. The fourth portion 340 of the transparent electrode 300 may be disposed in an inner region of the second region 10b of the handle layer configured with an inclined structure. The fourth portion 340 of the transparent electrode 300 may be disposed in a symmetrical structure on the basis of a center line with respect to the second portion 320. The fifth portion 350 of the transparent electrode 300 may be connected to the fourth portion 340 of the transparent electrode 300. The fifth portion 350 of the transparent electrode 300 may be disposed under the thin film 210 disposed under the second region 10b of the handle layer. The fifth portion 350 of the transparent electrode 300 may be disposed in a symmetrical structure on the basis of a center line with respect to the first portion 310.

Referring to (b) of FIG. 5, a second thin film 220 may be disposed in an inner region of a lower portion and a side surface of the transparent electrode 300. The second thin film 220 may be configured to include a first portion 221, a second portion 222, a third portion 223, and a fourth portion 224.

Referring to (a) and (b) of FIG. 5, the first portion 221 of the second thin film 220 may be disposed at a bottom of the first portion 310 of the transparent electrode 300. One side end portion of the second portion 222 of the second thin film 220 may be connected to the first portion 221 of the second thin film 220. The second portion 222 of the second thin film 220 may be disposed on an inner side of the second portion 320 of the transparent electrode 300. The other side end portion of the second portion 222 of the second thin film 220 may be extended to one side of a bottom of the third portion 330 of the transparent electrode 300 by a predetermined length. An opening region 220R between the second portion 222 and the fourth portion 223 of the second thin film 220 may be disposed to have a first opening length AL1.

The third portion 223 of the second thin film 220 may be disposed on an inner side of the fourth portion 340 of the transparent electrode 300. The fourth portion 224 of the second thin film 220 may be connected to one end portion of the third portion 223 of the second thin film 220. One end portion of the third portion 223 of the second thin film 220 may be extended to the other side of a bottom of the third portion 330 of the transparent electrode 300 by a predetermined length. An opening region 220R between the second portion 222 and the third portion 223 of the second thin film 220 may be disposed to have a first opening length AL 1.

The fourth portion 224 of the second thin film 220 may be disposed on a bottom of the fifth portion 350 of the transparent electrode 300. An opening region 220R between the first portion 221 and the fourth portion 224 of the second thin film 220 may be disposed to have a second opening length AL2. The second opening length AL2 of the opening region 220R may be disposed to be smaller than the first opening length AL1. Accordingly, a light collection region by the light-emitting elements to be disposed in a lower region of the opening region 220R may be concentrated to a region having the first opening length AL1, thereby increasing the emission current. In addition, a space in which light-emitting elements to be disposed in a lower region of the opening region 220R are to be disposed may be extended by a space having the second opening length AL2.

Referring to FIGS. 6 and 7, a lower structure 1000b of a package having a field emission element according to this specification will be described. A wafer-shaped substrate to which an LED is joined may be disposed on the lower structure 1000b of the package.

In order to implement an element by joining a wafer-shaped substrate to which an LED is joined to a field emission element, it is very important to reduce a residual stress caused by a difference of thermal expansion coefficients. In order to manufacture an X-ray tube using a completed device, a high temperature of at least 350 °C is required, and when the thermal expansion coefficients of the field emission element and the LED joining substrate are different, a large residual stress may occur, which may cause the element to be destroyed.

An aluminum oxide ($Al_2O_3$) substrate or PCB may be used as an LED substrate. However, the LED substrate implemented with the aluminum oxide ($Al_2O_3$) substrate or PCB is not preferable in terms of thermal expansion coefficient. In order to solve the foregoing problem, the present disclosure aims to implement an LED bonding substrate using a silicon wafer, which is the same material as that of the field emission element.

(a) to (c) of FIG. 6 show a manufacturing process of a substrate to which a light-emitting element such as an LED is to be joined. Referring to (a) of FIG. 6, an SOI wafer 1010 made of a silicon material may be prepared.

Referring to (b) of FIG. 6, the SOI wafer 1010 made of a silicon material in a portion where the anode electrode of the LED is to be disposed may be etched. As the SOI wafer 1010 made of a silicon material is etched to form a recessed region 1010a, a structure capable of easily preventing an electrical short circuit between a cathode and an LED anode when an LED integrated substrate is joined to a field emission element may be created. The recessed region 1010a may be disposed in a central portion of the wafer 1010 made of a silicon material, and the protruding regions 1010b, 1010c may be disposed on both sides thereof.

Referring to (c) of FIG. 6, a first oxide layer 1110 and a second oxide layer 1120 may be deposited as an insulating film on the SOI wafer 1010 to insulate the substrate. Accordingly, the first oxide layer 1110 and the second oxide layer 1120 may be referred to as a first insulating film and a second insulating film, respectively. As the insulating film, the first oxide layer 1110 and the second oxide layer 1120 may be deposited as an oxide layer made of a silicon dioxide (SiO2) material through thermal oxidation.

(a) and (b) of FIG. 7 show a process of forming electrodes on an insulating film of the SOI wafer 1010 and placing a light-emitting element such as an LED thereon to implement connection wiring. Referring to (a) of FIG. 7, electrodes to be used as cathodes of a light-emitting element and a field emission element may be formed. First metal electrodes 1210, 1220 to be connected to an upper structure of a package having a field emission element may be formed on protruding regions 1010b, 1010c of the SOI wafer 1010. The second metal electrode 1230 may be disposed in the recessed region 1010a of the SOI wafer 1010 on which the light-emitting element is to be disposed. An Au material may be used as an electrode material, and an adhesion layer such as Cr or Ti may be first deposited between SiOz and Au.

Next, a material such as Au-Sn may be formed at a junction portion for eutectic bonding to the field emission element. Various materials such as Au-Sn and Ag-Sn may be used as eutectic bonding materials. Referring to (b) of FIG. 7, a light-emitting element 400 may be disposed and die-bonded to a second metal electrode 1230 corresponding to an anode. At least one of the first metal electrodes 1210, 1220 and the light-emitting element 400 may be electrically connected to each other. At least one of the first metal electrodes 1210, 1220 and the light-emitting element 400 may be connected through wire bonding. Meanwhile, a lower region 1000b of the package may be joined and coupled to an upper region 1000a of the package of FIG. 5 through a soldering region 230. A width of the soldering region 230 may be disposed to be narrower than those of the first metal electrodes 1210, 1220.

Die bonding and wire bonding of the light-emitting element 400 are performed to form electrodes for connecting a cathode and an anode of the light-emitting element 400. For the light-emitting element 400, a laser diode (LD) may be used instead of an LED to increase the straightness of light.

In addition, various wavelengths of light from LEDs and LDs may be used for the light-emitting element 400. In this regard, as the wavelength decreases, an absorption rate of the silicon material decreases. Therefore, in order to ensure that light is transmitted well to an element on a silicon surface, an LED and an LD having an appropriate wavelength must be selected according to a thickness of the device layer. Meanwhile, in addition to blue and red LEDs, an infrared LED having an appropriate wavelength may be used for the light-emitting element 400.

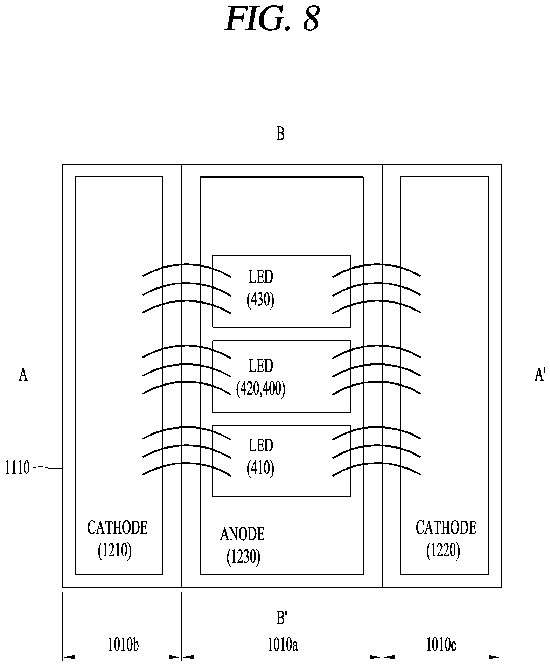

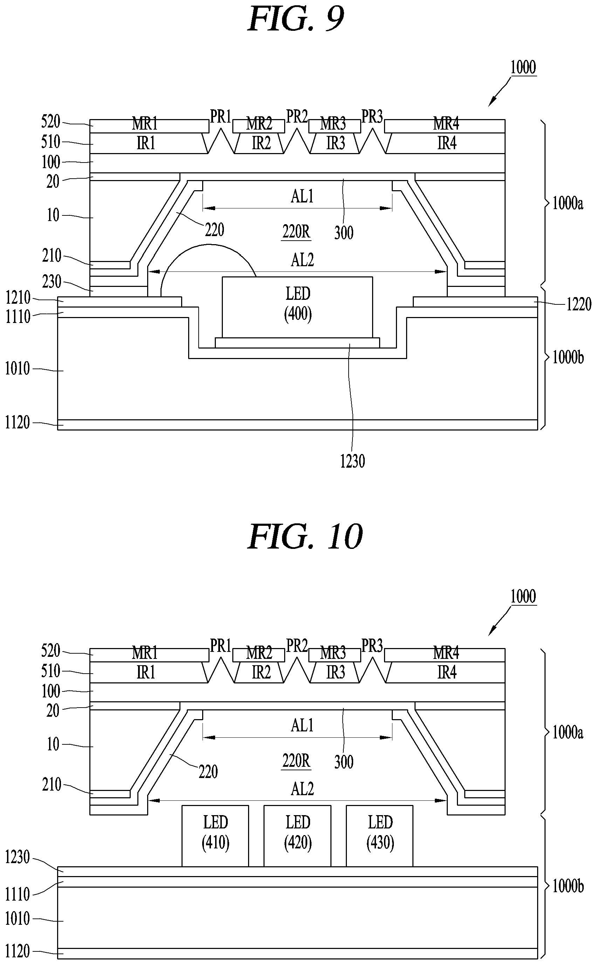

Meanwhile, FIG. 8 shows a plan view of a lower structure of FIG. 6 in which light-emitting elements are disposed. FIGS. 9 and 10 show cross-sectional views along different axes of a package having a field emission element in which light-emitting elements are disposed in a lower structure thereof.

Referring to (b) of FIG. 7 and FIG. 8, a lower structure 1000b of the package having a field emission element may be provided with first metal electrodes 1210, 1220 and a second metal electrode 1230. The first metal electrodes 1210, 1220 corresponding to cathodes may be disposed on the protruding regions 1010b, 1010c of the SOI wafer The second metal electrode 1230 may be disposed in the recessed region 1010a of the SOI wafer.

Light-emitting elements 410, 420, 430 may be disposed on a second metal electrode 1230 formed in the recessed region 1010a of the wafer. One side and the other side of each of the light-emitting elements 410, 420, 430 may be connected to the first metal electrodes 1210, 1220 by wire bonding.

FIG. 9 shows a cross-sectional view along line AA' in a horizontal axis direction of a package having a field emission element in which the light-emitting elements of FIG. 8 are disposed. FIG. 9 shows a cross-sectional view of a cathode junction portion in a horizontal axis direction where the light-emitting element 400 is disposed. FIG. 10 shows a cross-sectional view along line BB' in a vertically axis direction of a package having a field emission element in which the light-emitting elements of FIG. 8 are disposed. FIG. 10 shows a cross-sectional view of an anode portion in a vertical axis direction where light-emitting elements 410, 420, 430 are disposed.

Referring to FIGS. 7 to 9, a cathode of the light-emitting element 400 is joined to a cathode of the field emission element and connected to a common ground. A space may be secured so as to disallow an anode of the light-emitting element 400 to be in contact with a cathode of the light-emitting element 400 due to a step in which the initial substrate is etched. The power of the light-emitting element 400 may be controlled by applying a voltage to an anode electrode of the light-emitting element 400.

A junction between the upper region 1000a and the lower region 1000b of the package is bonded using a eutectic bonding method, and is j oined by melting solder in a vacuum at temperatures of 300 to 450 °C. The upper region 1000a and the lower region 1000b of the package may be joined and coupled to each other through the soldering region 230. A width of the soldering region 230 may be disposed to be narrower than those of the first metal electrodes 1210, 1220.

A package 1000 having a field emission device according to this specification will be described with reference to FIGS. 4 to 10.

The package 1000 having a field emission element may be configured to include a device layer 100, a thin film 210, a transparent electrode 300, and a light-emitting device 400. The package 1000 may be configured to further include a handle layer 10, a buried layer 20, and a second thin film 220.

The buried layer 20 may be disposed to be stacked on the handle layer 10. The device layer 100 may be disposed to be stacked on the buried layer 20. The thin film 210 may be disposed to be stacked on a bottom of one side region and a bottom of the other side region of the handle layer 10. A central portion of the handle layer 10 may be removed by an etching process. The handle layer 10 is disposed at a bottom of one side region and a bottom of the other side region, and an opening region 220R may be disposed in the central portion.

The transparent electrode 300 may be disposed on a bottom of the thin film 210, an inner surface of one side region, and an inner surface of the other side region. The transparent electrode 300 may be disposed at a bottom of the device layer 100. At least one light-emitting element 400 may be disposed in a lower region of the transparent electrode 300. The light-emitting element 400 may be configured to emit light through the transparent electrode 300 and the device layer 100.

The package 1000 having a field emission element may be coupled to a structure in a lower region. The lower region structure of the package 1000 may include an SOI wafer 1010. The lower region structure of the package 1000 may further include a first oxide layer 1110 and a second oxide layer 1120. A lower region structure of the package 1000 may further include first metal electrodes 1210, 1220 and a second metal electrode 1230.

The wafer 1010 may be a silicon wafer, but is not limited thereto and may be changed depending on the application. A recessed region 1010a may be formed by an etching process in a central portion of the wafer 1010. One side region and the other side region of the central portion of the wafer 1010 may be disposed with protruding regions 1010b, 1010c disposed to protrude beyond the recessed region 1010a.

A first thickness t1 from a bottom of the SOI wafer 1010 to tops of the protruding regions 1010b, 1010c may be disposed to be thicker than a second thickness t2 from the bottom of the wafer 1010 to a top of the recessed region 1010a.

The first oxide layer 1110 may be disposed in the recessed region 1010a on the top of the wafer 1010 and the protruding regions 1010b, 1010c on one side and the other side of the recessed region 1010a. The second oxide layer 1120 may be disposed on the bottom of the wafer 1010. The first oxide layer 1110 and the second oxide layer 1120 disposed on the top and bottom of the wafer 1010, respectively, constitute an insulating film. Accordingly, the first oxide layer 1110 and the second oxide layer 1120 may be referred to as a first insulating layer and a second insulating layer, respectively.

First metal electrodes 1210, 1220 may be disposed on the protruding regions 1010b, 1010c of the wafer 1010. The second metal electrode 1230 may be disposed in the recessed region 1010a of the wafer 1010. The light-emitting element 400 may be disposed on the second metal electrode 1230.

The first metal electrodes 1210, 1220 may constitute LED cathodes. The second metal electrode 1230 may constitute an LED anode. A bottom of the light-emitting element 400 may be disposed in the recessed region 1010a where the second metal electrode 1230 is disposed. A top of the light-emitting element 400 may be disposed in an opening region of the handle layer 10, which is an upper structure of the package 1000.

The light-emitting element 400 may include a plurality of LEDs 410, 420, 430 spaced apart from one another on a vertical axis in a region where the second metal electrode 1230 is disposed. The light-emitting element 400 is not limited to an LED and may be implemented as any light-emitting element. One side and the other side of each of the plurality of LEDs 410, 420, 430 may be connected to the first metal electrodes 1210, 1220 on one side and the other side of the protruding region 1010b, 1010c of the wafer 1010 by wire bonding. One side and the other side of each of the plurality of LEDs 410, 420, 430 may also be connected to the first metal electrodes 1210, 1220 by a bonding structure other than wire bonding. For example, one side and the other side of each of the plurality of LEDs 410, 420, 430 may be connected to the first metal electrodes 1210, 1220 through a bonding structure of an internal region of the wafer 1010.

An upper structure and a lower structure of the package 1000 may be coupled to each other through one side region and the other side region. The second thin film 220 at a bottom of the upper structure of the package 1000 may be connected to the first metal electrodes 1210, 1220 constituting LED cathodes at a top of the lower structure of the package 1000.

The upper structure of the package 1000 may be configured to further include an insulating layer 510 and a gate electrode 520. The insulating layer 510 may be disposed to be stacked on an upper region of the device layer 100. The gate electrode 520 may be disposed to be stacked on an upper region of the insulating layer 510.

The insulating layer 510 may be configured with a plurality of insulating regions IR1, IR2, IR3, IR4 separated by first separation regions. The gate electrode 520 may be configured with a plurality of metal regions MR1, MR2, MR3, MR4 separated by second separation regions. Each of the plurality of metal regions MR1, MR2, MR3, MR4 of the gate electrode 520 may be disposed to be stacked on each of the plurality of insulating regions IR1, IR2, IR3, IR4 of the insulating layer 510.

The device layer 100 may be provided with protruding portions PR1, PR2, PR3. The protruding portions PR1, PR2, PR3 of the device layer 100 may be disposed to protrude between the insulating regions IR1, IR2, IR3, IR4 and the metal regions MR1, MR2, MR3, MR4. The positions of tops of the protruding portions PR1, PR2, PR3 may be disposed to be higher than those of tops of the insulating regions IR1, IR2, IR3, IR4 on a Z-axis. The positions of the tops of the protruding portions PR1, PR2, PR3 may be disposed to be higher than those of tops of the metal regions MR1, MR2, MR3, MR4 on the Z-axis.

The second thin film 220 in the upper structure of the package 1000 may be disposed to correspond to a shape of the transparent electrode 300. The second thin film 220 in the upper structure of the package 1000 may be disposed on a bottom of the transparent electrode 300 and an inner surface of one side region and an inner surface of the other side region of the transparent electrode 300.

The second thin film 220 may constitute an opening region 220R to correspond to a central portion of the transparent electrode 300 stacked on the device layer 100. The opening region 220R of the second thin film 220 may be disposed to have a first opening length AL1 at a top of the handle layer 10. The opening region 220R of the second thin film 220 may be disposed to have a second opening length AL2 at a bottom of the handle layer 10. The second opening length AL2 of the opening region 220R of the second thin film 220 may be disposed to be larger than the first opening length AL1. A horizontal axis length of the light-emitting elements 400 may be disposed to be smaller than the first opening length AL1. Accordingly, direct light emitted from light-emitting elements 400 having a predetermined wide angle may be transmitted to an upper structure of the package 1000 through the transparent electrode 300. In addition, an interference signal caused by an external optical signal or an optical signal diffusely reflected from light-emitting elements 400 may be blocked by the second thin film 200 made of a metal material.

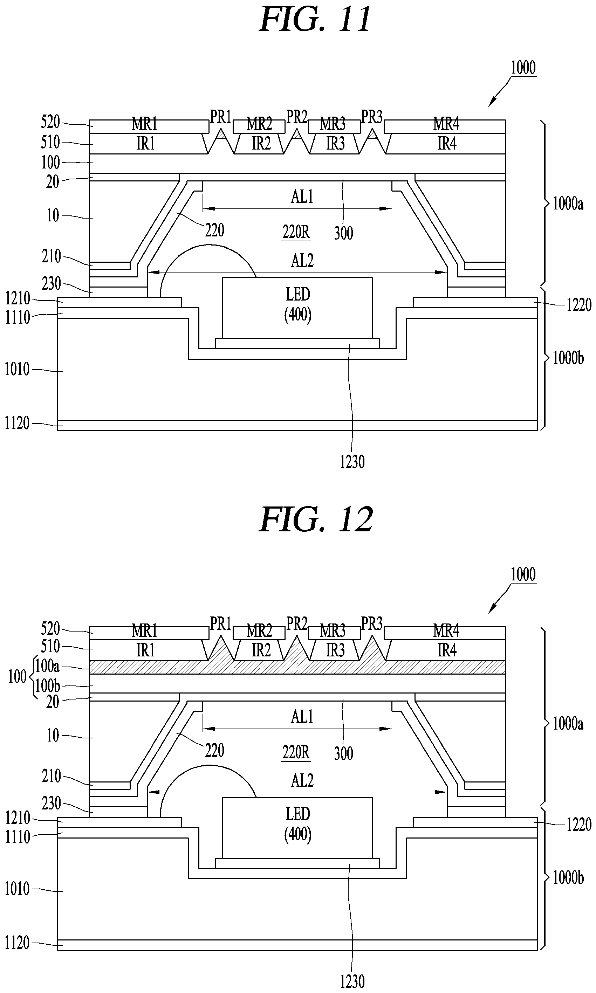

The device layer 100 may be disposed with a p-type silicon substrate. The protruding portions PR1, PR2, PR3 of the device layer 100 may be formed of n-type silicon. A depletion layer with respect to a vacuum may be disposed by using a P-type silicon substrate to form electrons and holes by light, thereby increasing the photocurrent. However, the efficiency may be further increased through a P-N junction structure. In this regard, FIGS. 11 and 12 show cross-sectional views of an LED integrated device having a P-N junction according to embodiments.

Referring to FIGS. 4 to 11, upper regions of the protruding portions PR1, PR2, PR3 may be formed of n-type silicon. Lower regions of the protruding portions PR1, PR2, PR3 and a body portion of the device layer 100 may be disposed with a p-type silicon substrate. A body portion of the device layer 100 may be disposed to be flat to allow an insulating layer 510 to be disposed on a top thereof.

It may also be formed by doping n-type dopants in upper regions of the protruding portions PR1, PR2, PR3 as shown in FIG. 11. On the other hand, it may also be formed by doping n-type dopants into the protruding portions PR1, PR2, PR3 and a portion of the substrate as shown in FIG. 12. When n-type dopants are confined to the upper regions of the protruding portions PR1, PR2, PR3 as shown in FIG. 10, a photocurrent is generated for each individual probe portion. Therefore, the crosstalk of photocurrents of the protruding portions PR1, PR2, PR3 does not occur, thereby reducing the possibility of arcing to occur. However, an area from which a photocurrent is generated is small, and thus there is a limitation in sufficiently increasing the photocurrent.

Referring to FIGS. 4 to 10 and 12, the protruding portions PR1, PR2, PR3 and an upper region 100a of a body portion of the device layer 100 disposed integrally with the protruding portions may be formed of n-type silicon. A lower region 100b of the body portion of the device layer 100 may be disposed with a p-type silicon substrate. The upper region 100a of the body portion of the device layer 100 and the lower region 100b of a body portion of the device layer 100 constitute the device layer 100. The buried layer 20 may be disposed to be stacked in the lower region 100b of the body portion of the device layer 100.

When n-type dopants are formed on the protruding portions PR1, PR2, PR3 and part of the substrate as shown in FIG. 12, a high photocurrent may be obtained. However, since the photocurrent is not limited to each of the protruding portion PR1, PR2, PR3, which is each individual probe portion, a crosstalk may occur, and thus there may be a reliability problem such as arcing. Therefore, the structure of FIG. 10 or the structure of FIG. 12 may be appropriately selected in consideration of the required emission current, reliability, and the like.

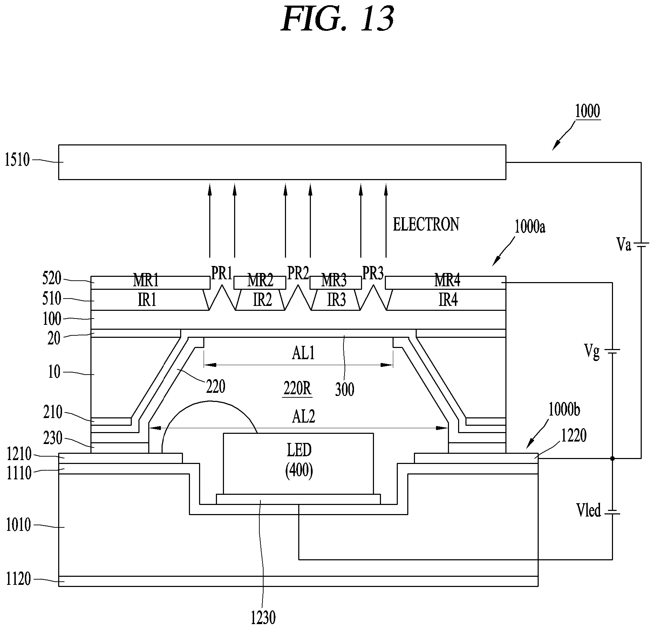

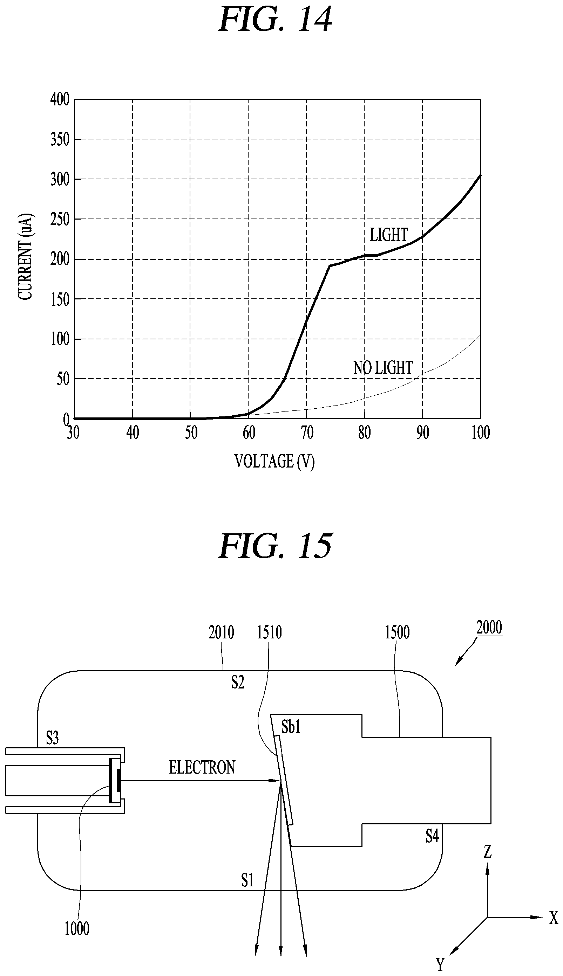

Meanwhile, the package 1000 having a field emission element according to this specification may be configured to emit a photocurrent when bias voltages are applied thereto. In this regard, FIG. 13 shows a configuration in which bias voltages are applied to a package having a field emission element. Meanwhile, FIG. 14 shows an emission current emitted through light-emitting elements according to a change of a gate voltage.

Referring to FIG. 13, an upper region 1000a and a lower region 1000b of the package 1000 having a field emission element may be joined to each other. The package 1000 having a field emission element may be configured as shown in FIG. 13 to be implemented as an X-ray emitter.

A cathode of the light-emitting element 400 and a cathode of the field emission element are connected to the ground. A gate voltage Vg of the field emission element is connected to the gate electrode 520 of the field emission element, and a drive voltage Vied of the light-emitting element 400 is connected to an anode of the light-emitting element 400. In addition, an acceleration voltage is applied to a metal plate of the anode layer 1510 to emit X-rays. Tungsten may be used as the metal plate of the anode layer 1510, but is not limited thereto and may be changed depending on the application. The acceleration voltage applied to the metal plate of the anode layer 1510 may be a voltage in a range of 20 to 150 kV.

The emission current of the light-emitting element 400 may be controlled by controlling a current of the light-emitting element 400 while maintaining the gate voltage Vg of the field emission element to be constant. The gate voltage Vg of the field emission element may be varied to have a range of about 50 to 150 V depending on the element.

Referring to FIG. 14, an emission current according to a change in a gate voltage of the field emission element is shown. In this regard, a number of protruding portions PR1, PR2, PR3 in FIG. 13 is 52,500, and an area thereof is 18.9 cm$^2$. When the drive voltage Vied is applied through the light-emitting element 400, it can be seen that the current increases to approximately 200 μA.

Referring to FIGS. 4 to 14, bias voltages applied to metal electrodes of the package 100 having a field emission element and an operation thereof will be described. A gate voltage Vg may be applied to at least one of the gate electrode 520 and the first metal electrodes 1210, 1220. The drive voltage Vied may be applied to at least one of the second metal electrode 1230 and the first metal electrodes 1210.

Meanwhile, the anode layer 1510 may be disposed on a surface of a detector 1500 configured to detect an electron beam from a field emission element. An anode voltage Va may be applied to the anode layer 1510. The gate voltage Vg may be varied. For example, the gate voltage Vg output from a variable DC-DC converter may be varied in a range of 50 V to 150 V An output port of the variable DC-DC converter is connected to the gate electrode 520.

A fixed voltage output from a DC-DC converter may be applied as the anode voltage Va. An output port of the DC-DC converter is connected to the anode layer 1510. For example, a fixed voltage in a range of 20 kV to 150 kV may be applied as the anode voltage Va. When the drive voltage Vied is not applied, the emission current of the electron beam emitted by the light-emitting elements 400 may increase as the gate voltage Vg increases. For example, the emission current of an electron beam emitted by the light-emitting elements 400 may increase from 0 μA to 100 μA when the gate voltage Vg is in a range of 50 V to 100 V

When the light-emitting element 400 emits light due to the application of the drive voltage Vled, the emission current may increase at a first slope in a range of a gate voltage Vg from 50 V to a first drive voltage. When the light-emitting element 400 emits light, the emission current may increase at a second slope that is less than the first slope in a range of the gate voltage Vg from the first drive voltage to 100 V The emission current may be greater than 100 μA at the first drive voltage.

In the above, the package 1000 having a field emission element according to one aspect of this specification has been described. Hereinafter, an X-ray device having a field emission element according to another aspect of this specification will be described. In this regard, FIG. 15 shows a configuration of an X-ray device having a field emission element according to this specification. In this regard, this specification relates to an element that applies light to a p-type or p-n junction type element to form electron-hole pairs so as to increase an emission current.

Referring to FIG. 15, an X-ray device 2000 having a field emission element may be configured to include a body 2010, an electron emission device 1000, and an X-ray emission device 1500. In order to increase an emission current in the X-ray device 2000 having an X-ray tube structure, an LED or the like that applies light to the electron emission device 1000 may be separately attached thereto. In this case, there is a problem in that a size of the X-ray tube becomes larger, and it is difficult to form a lens for focusing electrons. Additionally, it is also difficult to efficiently focus light onto the X-ray emission device 1500.

Therefore, in order to solve the foregoing problem, the electron emission device 1000 that emits an electron beam associated with an X-ray may be disposed on one side of the X-ray device 2000. For the electron emission device 1000, an upper structure 1000a and a lower structure 1000b of the package 1000 having the field emission element of FIGS. 4 to 14 may be bonded to each other.

Meanwhile, the body 2010 may have a front surface S1, a rear surface S2 and a plurality of side surfaces. The body 2010 may constitute an exterior of the X-ray device 2000. The electron emission device 1000 may be positioned internally through one side surface S3 of the body 2010. The electron emission device 1000 may correspond to the package 1000 having the field emission element of FIGS. 4 to 14. Accordingly, all the configurations and features of the package 1000 having the field emission element of FIGS. 4 to 14 may be applied to the X-ray device 2000 having the field emission element below.

The X-ray emission device 1500 may be disposed internally through the other side surface S4 of the body 2010. The X-ray emitting device 1500 may be configured with a metal target to reflect an electron beam emitted from the electron emission device 1000 and collide therewith at high energy so as to emit and radiate X-rays to an outside of the body 2010 through the front surface S1 of the body 2010.

An anode layer 1510 may be disposed to collide with electrons emitted from an electron emission device 1000 on a front surface Sb1 of the X-ray emission device 1500. The front surface Sb1 of the X-ray emission device 1500 may be configured with an inclined structure so as to be tilted at a predetermined angle with respect to the Z axis. Accordingly, the anode layer 1510 positioned on the front Sb1 of the X-ray emission device 1500 may also be configured with an inclined structure so as to be tilted by a predetermined angle with respect to the Z axis.

Referring to FIGS. 4 to 15, an X-ray device 2000 having a field emission element will be described. The electron emission device 1000 of the X-ray device 2000 may be configured to include a device layer 100, a thin film 210, a transparent electrode 300, and a light-emitting device 400. The electron emission device 1000 may be configured to further include a handle layer 10, a buried layer 20, and a second thin film 220.

The buried layer 20 may be disposed to be stacked on the handle layer 10. The device layer 100 may be disposed to be stacked on the buried layer 20. The thin film 210 may be disposed to be stacked on a bottom of one side region and a bottom of the other side region of the handle layer 10. A central portion of the handle layer 10 may be removed by an etching process.

The handle layer 10 is disposed at a bottom of one side region and a bottom of the other side region, and an opening region 220R may be disposed in the central portion.

The transparent electrode 300 may be disposed on a bottom of the thin film 210, an inner surface of one side region, and an inner surface of the other side region. The transparent electrode 300 may be disposed at a bottom of the device layer 100. At least one light-emitting element 400 may be disposed in a lower region of the transparent electrode 300. The light-emitting element 400 may be configured to emit light through the transparent electrode 300 and the device layer 100.

The electron emission device 1000 of the X-ray device 2000 having a field emission element may be coupled to a structure in a lower region. The lower region structure of the electron emission device 1000 may include a wafer 1010. The lower region structure of the electron emission device 1000 may further include a first oxide layer 1110 and a second oxide layer 1120. The lower region structure of the electron emission device 1000 may further include first metal electrodes 1210, 1220 and second metal electrode 1230.

The wafer 1010 may be a silicon wafer, but is not limited thereto and may be changed depending on the application. A recessed region 1010a may be formed by an etching process in a central portion of the SOI wafer 1010. One side region and the other side region of the central portion of the SOI wafer 1010 may be disposed with protruding regions 1010b, 1010c disposed to protrude beyond the recessed region 1010a.

A first thickness t1 from a bottom of the SOI wafer 1010 to tops of the protruding regions 1010b, 1010c may be disposed to be thicker than a second thickness t2 from the bottom of the wafer 1010 to a top of the recessed region 1010a.

The first oxide layer 1110 may be disposed in the recessed region 1010a on the top of the SOI wafer 1010 and the protruding regions 1010b, 1010c on one side and the other side of the recessed region 1010a. The second oxide layer 1120 may be disposed on the bottom of the SOI wafer 1010. The first oxide layer 1110 and the second oxide layer 1120 disposed on the top and bottom of the SOI wafer 1010, respectively, constitute an insulating film. Accordingly, the first oxide layer 1110 and the second oxide layer 1120 may be referred to as a first insulating layer and a second insulating layer, respectively.

First metal electrodes 1210, 1220 may be disposed on the protruding regions 1010b, 1010c of the SOI wafer 1010. The second metal electrode 1230 may be disposed in the recessed region 1010a of the SOI wafer 1010. The light-emitting element 400 may be disposed on the second metal electrode 1230.

The first metal electrodes 1210, 1220 may constitute LED cathodes. The second metal electrode 1230 may constitute an LED anode. A bottom of the light-emitting element 400 may be disposed in the recessed region 1010a where the second metal electrode 1230 is disposed. A top of the light-emitting element 400 may be disposed in an opening region of the handle layer 10, which is an upper structure of the package 1000.

The light-emitting element 400 may include a plurality of LEDs 410, 420, 430 spaced apart from one another on a vertical axis in a region where the second metal electrode 1230 is disposed. The light-emitting element 400 is not limited to an LED and may be implemented as any light-emitting element. One side and the other side of each of the plurality of LEDs 410, 420, 430 may be connected to the first metal electrodes 1210, 1220 on one side and the other side of the protruding region 1010b, 1010c of the wafer 1010 by wire bonding. One side and the other side of each of the plurality of LEDs 410, 420, 430 may also be connected to the first metal electrodes 1210, 1220 by a bonding structure other than wire bonding. For example, one side and the other side of each of the plurality of LEDs 410, 420, 430 may be connected to the first metal electrodes 1210, 1220 through a bonding structure of an internal region of the wafer 1010.

An upper structure and a lower structure of the package 1000 may be coupled to each other through one side region and the other side region. The second thin film 220 at a bottom of the upper structure of the package 1000 may be connected to the first metal electrodes 1210, 1220 constituting LED cathodes at a top of the lower structure of the package 1000.

The upper structure of the package 1000 may be configured to further include an insulating layer 510 and a gate electrode 520. The insulating layer 510 may be disposed to be stacked on an upper region of the device layer 100. The gate electrode 520 may be disposed to be stacked on an upper region of the insulating layer 510.

The insulating layer 510 may be configured with a plurality of insulating regions IR1, IR2, IR3, IR4 separated by first separation regions. The gate electrode 520 may be configured with a plurality of metal regions MR1, MR2, MR3, MR4 separated by second separation regions. Each of the plurality of metal regions MR1, MR2, MR3, MR4 of the gate electrode 520 may be disposed to be stacked on each of the plurality of insulating regions IR1, IR2, IR3, IR4 of the insulating layer 510.

The device layer 100 may be provided with protruding portions PR1, PR2, PR3. The protruding portions PR1, PR2, PR3 of the device layer 100 may be disposed to protrude between the insulating regions IR1, IR2, IR3, IR4 and the metal regions MR1, MR2, MR3, MR4. The positions of tops of the protruding portions PR1, PR2, PR3 may be disposed to be higher than those of tops of the insulating regions IR1, IR2, IR3, IR4 on a Z-axis. The positions of the tops of the protruding portions PR1, PR2, PR3 may be disposed to be higher than those of tops of the metal regions MR1, MR2, MR3, MR4 on the Z-axis.

The second thin film 220 in the upper structure of the package 1000 may be disposed to correspond to a shape of the transparent electrode 300. The second thin film 220 in the upper structure of the package 1000 may be disposed on a bottom of the transparent electrode 300 and an inner surface of one side region and an inner surface of the other side region of the transparent electrode 300.

The second thin film 220 may constitute an opening region 220R to correspond to a central portion of the transparent electrode 300 stacked on the device layer 100. The opening region 220R of the second thin film 220 may be disposed to have a first opening length AL1 at a top of the handle layer 10. The opening region 220R of the second thin film 220 may be disposed to have a second opening length AL2 at a bottom of the handle layer 10. The second opening length AL2 of the opening region 220R of the second thin film 220 may be disposed to be larger than the first opening length AL1. A horizontal axis length of the light-emitting elements 400 may be disposed to be smaller than the first opening length AL1. Accordingly, direct light emitted from light-emitting elements 400 having a predetermined wide angle may be transmitted to an upper structure of the package 1000 through the transparent electrode 300. In addition, an interference signal caused by an external optical signal or an optical signal diffusely reflected from light-emitting elements 400 may be blocked by the second thin film 200 made of a metal material.

The device layer 100 may be disposed with a p-type silicon substrate. The protruding portions PR1, PR2, PR3 disposed on the device layer 100 may be formed of n-type silicon. Hereinafter, bias voltages applied to metal electrodes of the electron emission device 1000 in the X-ray device 2000 having a field emission element and an operation thereof will be described. A gate voltage Vg may be applied to at least one of the gate electrode 520 and the first metal electrodes 1210, 1220. The drive voltage Vied may be applied to at least one of the second metal electrode 1230 and the first metal electrodes 1210.

Meanwhile, the anode layer 1510 may be disposed on a surface of a detector 1500 configured to detect an electron beam from a field emission element. The anode layer 1510 may be disposed to be inclined at a predetermined angle on the Z axis. The anode voltage Va may be applied to at least one of the anode layer 1510 and the first metal electrodes 1210, 1220. The gate voltage Vg may be varied in a range of 50 V to 150 V

A fixed voltage in a range of 20 kV to 150 kV may be applied as the anode voltage Va. When the drive voltage Vied is not applied, the emission current of an electron beam emitted by the light-emitting elements 400 may increase from 0 μA to 100 μA when the gate voltage Vg is in a range of 50 V to 100 V.

When the light-emitting element 400 emits light due to the application of the drive voltage Vled, the emission current may increase at a first slope in a range of a gate voltage Vg from 50 V to a first drive voltage. When the light-emitting element 400 emits light, the emission current may increase at a second slope that is less than the first slope in a range of the gate voltage Vg

from the first drive voltage to 100 V The emission current may be greater than 100 μA at the first drive voltage.

In the above, a package including a field emission element and an X-ray device including the same has been described. The technical effects of a package having a field emission element and an X-ray device having the same will be described as follows.

According to this specification, a package having a field emission element and an X-ray device having the same may be provided.

According to this specification, a current of each individual probe may be effectively controlled to increase current density and secure reliability in a package and X-ray device.

According to this specification, a structure and method of an element integrated with a probe formed from a p-type wafer and an LED (or LD) may be provided by using a principle that carriers are generated when a p-type or p-n junction receives light energy.

According to this specification, a current may be controlled by light of a light-emitting element to ensure reliability by preventing an excessive current from flowing through each individual probe and to control a current density for emitting electrons by controlling an intensity of LED light.

Further scope of applicability of the present disclosure will become apparent from the foregoing detailed description. It should be understood, however, that the detailed description and specific examples, such as the preferred embodiments of the present disclosure, are given by way of illustration only, since various modifications and alternations within the concept and scope of the disclosure will be apparent to those skilled in the art.

**Claims**

1. A package (1000) having a field emission element, the package comprising:

   a handle layer (10);
   a buried layer (20) stacked on the handle layer (10);
   a device layer (100) stacked on the buried layer (20);
   an insulating layer (510) stacked in an upper region of the device layer (100);
   a gate electrode (520) stacked in an upper region of the insulating layer (510); and
   at least one light-emitting element (400) disposed in a lower region of the device layer (100), and configured to emit light through the device layer (100),
   wherein the insulating layer (510) is configured with a plurality of insulating regions (IR1, IR2, IR3, IR4) separated by first separation regions, and the gate electrode (520) is configured with a plurality of metal regions (MR1, MR2, MR3, MR4) separated by second separation regions, and

wherein the device layer (100) is provided with protruding portions (PR1, PR2, PR3) disposed to protrude between the first separation regions that are between the insulating regions (IR1, IR2, IR3, IR4) and the second separation regions that are between the metal regions (MR1, MR2, MR3, MR4).

2. The package (1000) of claim 1, wherein the device layer (100) is disposed with a p-type silicon substrate, and
wherein the protruding portions (PR1, PR2, PR3) of the device layer (100) are formed of n-type silicon.

3. The package (1000) of claim 1 or 2, wherein an upper region of the protruding portions (PR1, PR2, PR3) is formed of n-type silicon,

wherein a lower region of the protruding portions (PR1, PR2, PR3) and a body portion of the device layer (100) are disposed with a p-type silicon substrate, and
wherein the body portion of the device layer (100) is disposed to be flat so as to allow the insulating layer (510) to be disposed on atop thereof.

4. The package (1000) of claim 1 or 2, wherein the protruding portions (PR1, PR2, PR3) and an upper region of a body portion of the device layer (100) disposed integrally with the protruding portions (PR1, PR2, PR3) are formed of n-type silicon,

wherein a lower region of the body portion is disposed with a p-type silicon substrate, and
wherein the buried layer (20) is stacked on a bottom of the lower region of the body portion.

5. The package (1000) of any one of claims 1 to 4, further comprising:

an SOI wafer (1010) having a recessed region (1010a) at a central portion thereof,
wherein one side region and another side region of the central portion (1010a) of the wafer (1010) comprise protruding regions (1010b, 1010c) disposed to protrude beyond the recessed region (1010a), and
wherein a first thickness (t1) from a bottom of the wafer (1010) to tops of the protruding regions (1010b, 1010c) is disposed to be thicker than a second thickness (t2) from the bottom of the wafer (1010) to a top of the recessed region (1010a).

6. The package (1000) of claim 5, further comprising:

a first oxide layer (1110) disposed in the recessed region (1010a) on a top of the wafer and in protruding regions (1010b, 1010c) on one side and another side of the recessed region (1010a);
a second oxide layer (1120) disposed on a bottom of the wafer (1010);
first metal electrodes (1210, 1220) disposed in the protruding regions (1010b, 1010c); and
a second metal electrode (1230) disposed in the recessed region (1010a),
wherein the light-emitting element (400) is disposed on a top of the second metal electrode (1210, 1220).

7. The package (1000) of claim 6, wherein the first metal electrodes (1210, 1220) constitute LED cathodes, and the second metal electrode (1230) constitutes an LED anode, and
wherein a bottom of the light-emitting element (400) is disposed in the recessed region (1010a) in which the second metal electrode (1230) is disposed, and a top of the light-emitting element (400) is disposed in an opening region (220R) of the handle layer (10).

8. The package (1000) of claim 7, wherein the light-emitting element (400) is disposed with a plurality of LEDs (410, 420, 430) spaced apart on a vertical axis in a region where the second metal electrode (1230) is disposed, and
wherein one side and another side of each of the plurality of LEDs (410, 420, 430) are connected to the first metal electrodes (1210, 1220) of one side and another side of the protruding region (1010b, 1010c) by wire bonding.

9. The package (1000) of any one of claims 1 to 8, comprising:

a thin film (210) stacked on a bottom of one side region and a bottom of another side region of the handle layer (10), and the handle layer (10) is disposed on the one side region and an other side region to allow an opening region (220R) to be disposed in a central portion of the handle layer (10) that is removed by an etching process; and
a transparent electrode (300) disposed on a bottom of the thin film (210), an inner surface of the one side region, an inner surface of the other side region, and a bottom of the device layer (100).

10. The package (1000) of claim 9, comprising:

a second thin film (220) disposed on a bottom of the transparent electrode (300), and an inner surface of one side region and an inner surface of the other side region of the transparent electrode (300),

wherein the second thin film (220) constitutes the opening region (220R) disposed at a central portion of the transparent electrode (300) stacked on the device layer (100), and

wherein the opening region (220R) is disposed to have a first opening length (AL1) at a top of the handle layer (10), and disposed to have a second opening length (AL2) at a bottom of the handle layer (10).

11. The package (1000) of claim 9, wherein the second opening length (AL2) is disposed to be larger than the first opening length (AL1), and

wherein a horizontal axis length of the light-emitting elements (400) is disposed to be smaller than the first opening length (AL1).

12. The package (1000) of any one of claims 6 to 11, wherein a gate voltage (Vg) is applied to at least one of the gate electrode (520) and the first metal electrodes (1210, 1220), and

wherein a drive voltage (Vied) is applied to at least one of the second metal electrode (1230) and the first metal electrodes.

13. The package (1000) of claim 12, wherein an anode layer (1510) is disposed on a surface of a detector (1500) configured to detect an electron beam from the field emission element, and

wherein an anode voltage (Va) is applied to at least one of the anode layer (1510) and the first metal electrodes (1210, 1220).

14. The package (1000) of claim 13, wherein the gate voltage (Vg) is varied,

wherein a fixed voltage is applied to the anode voltage (Va), and

wherein an emission current of an electron beam emitted by the light-emitting elements (400) increases as the gate voltage (Vg) increases when the drive voltage (Vied) is not applied.

15. The package (1000) of claim 14, wherein when the light-emitting element (400) emits light due to the application of the drive voltage (Vied), the emission current increases at a first slope in a range of the gate voltage (Vg) from 50 V to a first drive voltage,

wherein when the light-emitting element (400) emits light, the emission current increases at a second slope that is smaller than the first slope in a range of the gate voltage (Vg) from the first drive voltage to 100 V, and

wherein the emission current is greater than 100 µA at the first drive voltage.

**Amended claims in accordance with Rule 137(2) EPC.**

1. A package (1000) having a field emission element, the package comprising:

a handle layer (10);

a buried layer (20) stacked on the handle layer (10);

a device layer (100) stacked on the buried layer (20);

an insulating layer (510) stacked in an upper region of the device layer (100);

a gate electrode (520) stacked in an upper region of the insulating layer (510); and

at least one light-emitting element (400) disposed in a lower region of the device layer (100), and configured to emit light through the device layer (100),

wherein the insulating layer (510) is configured with a plurality of insulating regions (IR1, IR2, IR3, IR4) separated by first separation regions, and the gate electrode (520) is configured with a plurality of metal regions (MR1, MR2, MR3, MR4) separated by second separation regions, and

wherein the device layer (100) is provided with protruding portions (PR1, PR2, PR3) disposed to protrude in the first separation regions that are between the insulating regions (IR1, IR2, IR3, IR4) and in the second separation regions that are between the metal regions (MR1, MR2, MR3, MR4), wherein the device layer (100) comprises a p-type silicon substrate, and

wherein the protruding portions (PR1, PR2, PR3) of the device layer (100) are formed of n-type silicon,

the package (1000) further comprising:

an SOI wafer (1010) having a recessed region (1010a) at a central portion thereof, wherein one side region and another side region of the central portion (1010a) of the wafer (1010) comprise protruding regions (1010b, 1010c) disposed to protrude beyond the recessed region (1010a), and

wherein a first thickness (t1) from a bottom of the wafer (1010) to tops of the protruding regions (1010b, 1010c) is disposed to be thicker than a second thickness (t2) from the bottom of the wafer (1010) to a top of the recessed region (1010a),

a first oxide layer (1110) disposed in the recessed region (1010a) on a top of the wafer and in protruding regions (1010b, 1010c) on one side and another side of the recessed region (1010a);

a second oxide layer (1120) disposed on a bottom of the wafer (1010);

first metal electrodes (1210, 1220) disposed in the protruding regions (1010b, 1010c); and

a second metal electrode (1230) disposed in the recessed region (1010a),

wherein the light-emitting element (400) is disposed on a top of the second metal electrode (1210, 1220),

wherein the light-emitting element (400) includes a plurality of LEDs (410, 420, 430) spaced apart on a vertical axis in a region where the second metal electrode (1230) is disposed, and

wherein one side and another side of each of the plurality of LEDs (410, 420, 430) are connected to the first metal electrodes (1210, 1220) of one side and another side of the protruding region (1010b, 1010c) by wire bonding,

a first film (210) stacked on a bottom of one side region and a bottom of another side region of the handle layer (10), and the handle layer (10) is disposed on the one side region and an other side region to allow an opening region (220R) to be disposed in a central portion of the handle layer (10) that is removed by an etching process; and

a transparent electrode (300) disposed on a bottom of the first film (210), an inner surface of the one side region, an inner surface of the other side region, and a bottom of the device layer (100).

2. The package (1000) of claim 1, wherein an upper region of the protruding portions (PR1, PR2, PR3) is formed of n-type silicon,

wherein a lower region of the protruding portions (PR1, PR2, PR3) and a body portion of the device layer (100) are disposed with a p-type silicon substrate, and

wherein the body portion of the device layer (100) is disposed to be flat so as to allow the insulating layer (510) to be disposed on a top thereof.

3. The package (1000) of claim 1, wherein the protruding portions (PR1, PR2, PR3) and an upper region of a body portion of the device layer (100) disposed integrally with the protruding portions (PR1, PR2, PR3) are formed of n-type silicon,

wherein a lower region of the body portion comprises a p-type silicon substrate, and

wherein the buried layer (20) is stacked on a bottom of the lower region of the body portion.

4. The package (1000) of any one of claims 1 to 3, wherein the first metal electrodes (1210, 1220) constitute LED cathodes, and the second metal electrode (1230) constitutes an LED anode, and

wherein a bottom of the light-emitting element (400) is disposed in the recessed region (1010a) in which the second metal electrode (1230) is disposed and connected thereto, and a top of the light-emitting element (400) is disposed in an opening region (220R) of the handle layer (10).

5. The package (1000) of any one of claims 1 to 4, comprising:

a second film (220) disposed on a bottom of the transparent electrode (300), and an inner surface of one side region and an inner surface of the other side region of the transparent electrode (300),

wherein the second film (220) constitutes the opening region (220R) disposed at a central portion of the transparent electrode (300) stacked on the device layer (100), and

wherein the opening region (220R) is disposed to have a first opening length (AL1) at a top of the handle layer (10), and disposed to have a second opening length (AL2) at a bottom of the handle layer (10).

6. The package (1000) of any one of claims 1 to 5, wherein the second opening length (AL2) is disposed to be larger than the first opening length (AL1), and

wherein a horizontal axis length of the light-emitting elements (400) is disposed to be smaller than the first opening length (AL1).

7. The package (1000) of any one of claims 1 to 6, wherein when the light-emitting element (400) emits light due to the application of the drive voltage (Vled), the emission current increases at a first slope in a range of the gate voltage (Vg) from 50 V to a first drive voltage,

wherein when the light-emitting element (400) emits light, the emission current increases at a second slope that is smaller than the first slope in a range of the gate voltage (Vg) from the first drive voltage to 100 V, and

wherein the emission current is greater than 100 μA at the first drive voltage.

# FIG. 1

(a)

(b)

EMISSION CURRENT

# FIG. 2

(a)

PR1             PR2

520
510
1010
210

(b)

DEPLETION

p

VACUUM

e-h PAIR
GENERATION

(c)

$\log(I/V^2)$

1000/V

p-

p

# FIG. 3

(a)

(b)

(c)

# FIG. 4

(a)

— 100
— 20

— 10

(b)

MR1 | PR1 | MR2 | PR2 | MR3 | PR3 | MR4 — 520
IR1 | IR2 | IR3 | IR4 — 510
— 100
— 20

— 10

— 210

(c)

MR1 | PR1 | MR2 | PR2 | MR3 | PR3 | MR4 — 520
IR1 | IR2 | IR3 | IR4 — 510
— 100
— 20

L1a | L2a
10a | 220R | 10b — 10
L2a | L2b
— 210

# FIG. 5

(a)

MR1 · PR1 · MR2 · PR2 · MR3 · PR3 · MR4 — 520
IR1 · IR2 · IR3 · IR4 — 510
— 100
— 20
10a · 330 · 300 · 10b · 10
320 · 340
310 · 350 — 210

(b)

1000a

MR1 · PR1 · MR2 · PR2 · MR3 · PR3 · MR4 — 520
IR1 · IR2 · IR3 · IR4 — 510
— 100
— 20
AL1 · 300
10a · 222 · 223 · 10b · 10
220 · 220R
221 · 224 — 210
AL2

# FIG. 6

(a)

—1010

(b)

1010b

1010a

1010c

t1

t2

—1010

(c)

1110

1010b

1010a

1010c

t1

t2

1010

1120

# FIG. 7

(a)

230  1210

1230

1220
1110

1010b          1010c

1010a

1010

1120

(b)

1000b

1210  230

1230

1220
1110

LED
(400)

1010b          1010c

1010a

1010

1120

# FIG. 8

# FIG. 9

# FIG. 10

# FIG. 11

1000

520 — MR1    PR1    MR2    PR2    MR3    PR3    MR4
510 — IR1    IR2    IR3    IR4
100
20
10    AL1
220    220R    300
210    AL2
230
1210    LED
1110    (400)
1010
1120

1000a

1220

1000b

1230

# FIG. 12

1000

520 — MR1    PR1    MR2    PR2    MR3    PR3    MR4
510 — IR1    IR2    IR3    IR4
100 { 100a
       100b
20
10    AL1
220    220R    300
210    AL2
230
1210    LED
1110    (400)
1010
1120

1000a

1220

1000b

1230

# FIG. 13

ELECTRON

MR1 PR1 MR2 PR2 MR3 PR3 MR4

IR1 IR2 IR3 IR4

AL1

220 220R 300

AL2

LED
(400)

Va

Vg

Vled

# FIG. 14

# FIG. 15

Europäisches
Patentamt

European
Patent Office

Office européen
des brevets

## EUROPEAN SEARCH REPORT

Application Number

EP 24 21 6737

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 441 542 B1 (HUSH GLEN [US] ET AL) 27 August 2002 (2002-08-27) * figure 1 * * and corresponding description * ----- | 1-15 | INV. H01J1/304 H01J1/308 H01J35/06 |
| X | WO 2021/158454 A1 (KLA CORP [US]) 12 August 2021 (2021-08-12) * figures 5,6 * * and corresponding description * ----- | 1-15 | |
| X | WO 2018/071710 A2 (KLA TENCOR CORP [US]) 19 April 2018 (2018-04-19) * figures 4B,7 * * and corresponding description * ----- | 1-15 | |

|  |  |  | TECHNICAL FIELDS SEARCHED (IPC) |
|---|---|---|---|
|  |  |  | H01J |

The present search report has been drawn up for all claims

| Place of search | Date of completion of the search | Examiner |
|---|---|---|
| Munich | 22 April 2025 | Weisser, Wolfgang |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

   ........................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 21 6737

This annex lists the patent family members relating to the patent documents cited in the above-mentioned European search report.
The members are as contained in the European Patent Office EDP file on
The European Patent Office is in no way liable for these particulars which are merely given for the purpose of information.

22-04-2025

| Patent document cited in search report | | Publication date | Patent family member(s) | | Publication date |
|---|---|---|---|---|---|
| US 6441542 | B1 | 27-08-2002 | NONE | | |
| WO 2021158454 | A1 | 12-08-2021 | CN | 115136274 A | 30-09-2022 |
| | | | TW | 202203281 A | 16-01-2022 |
| | | | US | 2021239629 A1 | 05-08-2021 |
| | | | WO | 2021158454 A1 | 12-08-2021 |
| WO 2018071710 | A2 | 19-04-2018 | CN | 109891547 A | 14-06-2019 |
| | | | CN | 115083876 A | 20-09-2022 |
| | | | TW | 201826312 A | 16-07-2018 |
| | | | US | 2018108514 A1 | 19-04-2018 |
| | | | WO | 2018071710 A2 | 19-04-2018 |

EPO FORM P0459

For more details about this annex : see Official Journal of the European Patent Office, No. 12/82